# EUROPEAN PATENT APPLICATION

(11) **EP 1 971 024 A2**
(43) Date of publication of application: **17.09.2008**
(21) Application number: 08003733.6
(22) Date of filing: 28.02.2008
(51) Int. Cl.: H03F 1/52, H04N 5/60

(54) **Television set and audio output unit**

(30) Priority: 06.03.2007 JP 2007056356
(71) Applicant: Funai Electric Co., Ltd., Daito-shi, Osaka 574-0013 (JP)
(72) Inventor: Suzuki, Hirotsugu, Daito-shi Osaka 574-0013 (JP)
(74) Representative: Grünecker, Kinkeldey, Stockmair & Schwanhäusser Anwaltssozietät

(57) **Abstract**

An audio output device includes an audio control circuit outputting to an audio amplifier an audio control signal generated based on a volume signal supplied from an audio adjustment switch, the audio amplifier including a control IC, a power control circuit generating a predetermined drive voltage from a power supply voltage supplied thereto and supplying the generated drive voltage to the audio amplifier, and a microcomputer monitoring a temperature of the control IC of the audio amplifier and gradually reducing the audio control signal output from the audio control circuit and the drive voltage output from the power control circuit when the temperature of the control IC has reached a set temperature, the microcomputer gradually returning the audio control signal and the drive voltage to respective levels before reduction.

## Description

### Technical Field to which the Invention Belongs

The present invention relates to an audio output unit provided with a voice amplifier, and a television set.

### Related Background Art

Television sets displaying broadcast image on a display have long been popular in families as a key media on which we watch amusement programs, movies, news or the like. The size of a screen of the television set has been increased with improvement in living standards. However, CRT-based television sets which have long been predominant have problems in a depth, weight or dissipation power because of the structure thereof. An increase in the size of a cathode ray tube sees the end coming.

On the other hand, display devices such as plasma television sets and liquid crystal displays which quite differ from the cathode ray tube have recently been developed as the result of improvements in the electronic, semiconductor or material technique. These display devices are thinner as compared with the conventional cathode ray tube. Accordingly, television sets provided with these display devices are generally referred to as flat-screen television sets.

The flat-screen television sets have realized lower costs and larger size together with progress in the technical development and volume efficiency. The flat-screen television sets have now replaced the conventional cathode ray tube system and enlarged its market because of demand due to replacement with transition from terrestrial broadcasting to digital and in consistent with housing conditions in Japan.

The flat-screen television sets have been developed into high-definition television sets so as to meet high-definition broadcasting. Thus, the flat-screen television sets are capable of displaying fine high-quality dynamic images though having large-sized screens. With this, the number of viewers has increased who enjoy powerful video pictures such as movies or live music concerts through high-quality medium such as digital versatile disc (DVD) on a flat-screen television set installed in a living room or the like.

Functions viewers demand for the television sets in the above-described case include requirement of high audio performance as well as high video performance. In particular, a demand for high audio output such as in audio apparatus is high. Normal loud speakers equipped in television sets have been had lower performance. However, with such demand, some types of televisions having high audio performance comparable with those of audio apparatus have been developed.

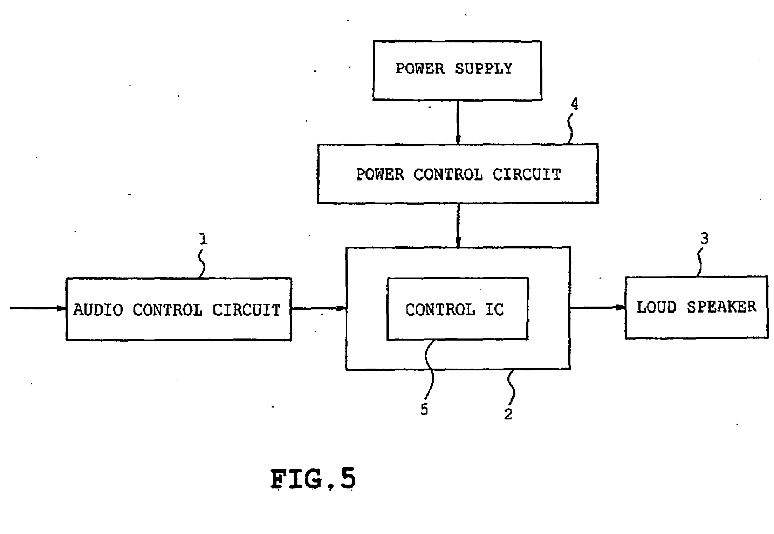

FIG. 5 is a block diagram showing audio output control in a flat-screen television set having high audio performance affording a larger volume of sound.

The aforesaid flat-screen television set comprises an audio control circuit 1 outputting an audio control signal based on a volume signal supplied from a remote-controller (not shown) or an audio adjustment switch provided on a television body, an audio amplifier 2 amplifying an audio control signal from the audio control circuit 1 to an audio output signal with a predetermined volume of sound, a loud speaker 3 producing sound based on the audio output signal supplied from the audio amplifier 2, and a power supply control circuit 4 controlling power supplied to obtain a suitable drive voltage and outputting the drive voltage to the audio amplifier 2.

The audio amplifier 2 includes a control IC 5 having an IC element die-bonded onto a radiator plate and wire-bonded to a connecting terminal, and resin-molded and mounted on a control circuit board of the flat-screen television. The control IC 5 generates heat in the case of amplification into the audio output signal with a predetermined volume of sound by the drive voltage supplied from the power supply control circuit 4. However, the heat is dissipated by the radiator plate, which suppresses temperature increase of the IC element.

However, when the viewer views with a larger volume of sound, an amount of heat from the IC element is increased such that heat radiation by the radiator plate becomes insufficient. As a result, since the temperature of the IC element rises, there is a possibility that the IC elements may thermally be destructed. In view of this problem, the control IC 5 is incorporated with a thermal protector circuit for preventing the aforementioned thermal destruction. The thermal protector circuit detects a temperature of the IC element and rapidly reduces an audio signal delivered to the loud speaker 3 by a large amount when the detected temperature has reached a predetermined temperature at which thermal destruction occurs, thereby dropping the temperature of the IC element for protection of the same. When the detected temperature has dropped below the predetermined temperature, the thermal protector circuit restores the original audio output signal.

When incorporated with the thermal protector circuit, the control IC 5 can in fact be protected against thermal destruction reliably even in the case where the viewer views with a large volume of sound. However, the audio output signal delivered to the loud speaker 3 is forced to rapidly be reduced by a large amount during operation of the thermal protector circuit. Accordingly, sound suddenly disappears and is suddenly returned to the original level when the detected temperature thereafter has dropped to or below the predetermined value. As a result, there is a possibility that the viewer may feel an intense sense of discomfort.

Furthermore, sound reduction by the thermal protector circuit need not be continued when an input mode of the thin television set is changed from receipt by an incorporated tuner to an external input such as DVD during the sound reduction by the thermal protector circuit. Despite this, unnecessary sound reduction is continued, causing the viewer to feel inconvenience.

The following are conventional techniques of reducing sound volume for preventing the temperature of the audio amplifier from increasing.

More specifically, JP-A-2004-112707 (hereinafter referred to as "first document") discloses an audio reproducer which supplies audio signals via a sound volume adjuster and a power amplifier to a loud speaker. A temperature detector is provided for detecting a temperature of the power amplifier. Sound volume of the sound volume adjuster is automatically reduced in a stepwise manner every time a temperature detected by the temperature detector reaches a predetermined set temperature.

JP-A-H11-355059 (hereinafter referred to as "second document") discloses an arrangement comprising a temperature detecting circuit detecting a temperature of an amplifier having exceeded a predetermined value, an oscillation circuit outputting periodic pulse signals according to output of the temperature detecting circuit, and a mute circuit attenuating an audio input signal according to the pulse signal delivered from the oscillation circuit.

JP-A-2001-274634 (hereinafter referred to as "third document") discloses an audio device comprising an acoustic signal amplifier having an electronic volume for controlling an amplification degree according to a control signal and an output amplifying circuit amplifying output of the acoustic signal amplifier and supplying the amplified output to a loud speaker. A temperature detector is provided for detecting an inner temperature of the audio device. The amplification degree is set at a predetermined value larger than zero when the state where the detected temperature is at or above a predetermined temperature continues for a first time period.

JP-A-H08-18349 (hereinafter referred to as "fourth document") discloses an arrangement comprising an output transistor amplifying input and output signals, a diode generating a constant voltage, a voltage divider circuit dividing the constant voltage, an attenuation circuit attenuating bias of the output transistor according to output of the voltage divider circuit, and a detector circuit detecting electric current which flows into the voltage divider circuit and which is at or above a predetermined voltage. An input voltage to the attenuation circuit is increased according to an output signal of the detector circuit.

According to the above-mentioned first document, sound volume of the sound volume adjuster is automatically reduced in a stepwise manner every time a temperature detected by the temperature detector reaches a predetermined set temperature. Consequently, the sound volume can certainly be prevented from sudden stop. However, since only the sound volume of the sound volume adjuster is adjusted in the disclosed arrangement, there is a possibility that temperature suppression may not catch up with the temperature increase when an amount of heat generated by the element is rapidly increased by a large amount during operation with a large sound volume, for example. In this case, there is a possibility of thermal destruction of the element. Furthermore, the first document cannot overcome the problem of unnecessary continuance of sound adjustment in the case where the input mode has been changed as described above.

According to the above-mentioned second document, the audio input signal is attenuated according to the pulse signal generated by the oscillation circuit. Consequently, the sound volume can certainly be prevented from sudden stop. However, since the mute circuit attenuates the audio input signal only by two levels, a sound volume the mute circuit can attenuate is limited, whereupon the mute circuit is insufficient to prevent thermal destruction in the case where a large amount of heat is generated by the element.

Furthermore, since only the sound volume (input signal) is adjusted in the second document as in the first document, there is also a possibility that temperature suppression may not catch up with the temperature increase when an amount of heat generated by the element is rapidly increased by a large amount during operation with a large sound volume, for example. In this case, there is a possibility of thermal destruction of the element.

Furthermore, the second document cannot overcome the problem of unnecessary continuance of sound adjustment in the case where the input mode has been changed as described above, either.

According to the above-mentioned third document, the amplification degree is set at the predetermined value larger than zero when the state where the detected temperature is at or above the predetermined temperature continues for the first time period. Consequently, the sound volume can certainly be prevented from sudden stop. However, since adjustment of the amplification degree depends upon a single set value, fine adjustment according to a state of heat generation cannot be carried out, When an amount of heat generated by the element is large, there is a possibility that temperature suppression cannot catch up with the temperature increase when an amount of heat generated by the element is large. In this case, there is a possibility of thermal destruction of the element. Furthermore, since only the sound volume (amplification degree) is adjusted in the third document as in the first document, there is also a possibility that temperature suppression may not catch up with the temperature increase when an amount of heat generated by the element is rapidly increased by a large amount during operation with a large sound volume, for example. In this case, there is a possibility of thermal destruction of the element.

Furthermore, the third document cannot overcome the problem of unnecessary continuance of sound adjustment in the case where the input mode has been changed as described above, either.

According to the above-mentioned fourth document, the output transistor is slowly controlled such that the sound volume can certainly be prevented from sudden stop. However, when the chip temperature still rises in spite of execution of the slow control, the output transistor is rapidly controlled. Accordingly, the sound volume is rapidly reduced when an amount of heat generated by the element is large. As a result, there is a possibility that the viewer may feel uncomfortable. Furthermore, since only the sound volume (control of the output transistor) is adjusted in the disclosed arrangement as in the first document, there is a possibility that temperature suppression may not catch up with the temperature increase when an amount of heat generated by the element is rapidly increased by a large amount during operation with a large sound volume, for example. In this case, there is a possibility of thermal destruction of the element.

Furthermore, the fourth document cannot overcome the problem of unnecessary continuance of sound adjustment in the case where the input mode has been changed as described above, either.

### Disclosure of the Invention

The present invention was made in view of the foregoing problems and an object thereof is to provide an audio output unit in which the control IC can be prevented from thermal destruction without operation of the thermal protector circuit incorporated with the control IC accompanying rapid sound reduction and restart while uncomfortableness the viewer feels during volume adjustment can be reduced and unnecessary adjustment during change in the input mode can be avoided, and a television set provided with the audio output unit.

To overcome the foregoing and other problems, the present invention provides a television set in which a predetermined image is displayed on a screen of a display based on an externally supplied image signal, the television comprising the display, a tuner extracting a broadcast signal corresponding to a selected channel from a received television broadcast signal and outputting the extracted signal, a controller carrying out control processing for video, audio, power supply and the like, a remote controller for carrying out power on/off, channel selection, volume adjustment, change to external input and the like in a wireless manner, an audio processor controlled by the controller so that audio processing is carried out, an OSD circuit displaying information of sound volume, a channel, an input mode and the like on the display, and a loud speaker producing sound based on audio output signal supplied from the audio processor. The audio processor includes an audio control circuit outputting an audio control signal based on a volume signal supplied from the remote controller or an audio adjustment switch equipped on a television body, an audio amplifier which carries out amplification into an audio output signal with a predetermined sound volume based on the audio control signal supplied from the audio control circuit, a power control circuit which controls an input power supply so that a predetermined drive voltage is arbitrarily obtained from the input power supply, outputting the obtained drive voltage to the audio amplifier, a microcomputer adjusting the audio control signal delivered from the audio control circuit and the drive voltage delivered from the power control circuit into respective predetermined levels, and an EEPROM storing respective levels of the audio control signal delivered from the audio control circuit and the drive voltage delivered from the power control circuit before adjustment by the microcomputer. The audio amplifier includes a control IC incorporated with a thermal protector circuit which rapidly reduces the audio output signal delivered to the loud speaker when a temperature of an element is increased to a temperature having a possibility of thermal destruction, thereby protecting the element, the control IC having a package and a radiator plate, and a temperature sensor detecting a temperature of the package or the radiator plate of the control IC. The microcomputer causes the EEPROM to store respective levels of the audio control signal output from the audio control circuit and the drive voltage output from the power control circuit just when the temperature of the control IC has reached a set temperature having a value reached immediately before actuation of the thermal protector circuit. The microcomputer reduces a level of the audio control signal output from the audio control circuit by a previously set first step amount that is a level at which a viewer does not feel uncomfortable and a level of the drive voltage output from the power control circuit by a previously set first voltage that is a level at which the viewer does not feel uncomfortable. The microcomputer thereafter controls the OSD circuit to display adjustment start information on the display and monitoring for a predetermined time period as to whether the temperature of the control IC is increased to or above a set temperature which is equal to a value immediately before actuation of the thermal protector circuit. The microcomputer reads values of an initial audio control signal and an initial drive voltage before adjustment both stored on the EEPROM to return the audio control signal and the drive voltage to the respective initial levels. The microcomputer simultaneously controls the OSD circuit to display adjustment completion information on the display. The microcomputer reduces the drive voltage level by a second step amount smaller than the first step amount when the temperature of the control IC in not reduced below the set temperature. The microcomputer re-monitoring for a predetermined time period as to whether the temperature of the control IC is increased to or above the set temperature which is equal to a value immediately before actuation of the thermal protector circuit. The microcomputer thereafter repeats a control of monitoring as to whether the temperature of the control IC is increased to or above the set temperature, a control of reducing the audio control signal and the drive voltage or returning the audio control signal and the drive voltage to the immediately preceding step amount and voltage and a control of thereafter monitoring the temperature of the control IC for a predetermined time period, the microcomputer controlling the OSD circuit to display adjustment completion information on the display. The microcomputer consequently controls the OSD circuit to display the adjustment completion information on the display when the audio control signal and the drive voltage have been returned to the respective initial values before adjustment. The microcomputer returns the levels of the audio control signal output from the audio control circuit and the drive signal output from the power control circuit to the respective initial values before adjustment stored on the EEPROM and controlling the OSD circuit to display adjustment cancel information on the display, whereby the levels of the audio control signal output from the audio control circuit and the drive voltage output from the power control circuit are previously are repeatedly adjusted step by step without actuation of the thermal protector circuit incorporated in the control IC, thereby reducing uncomfortableness of the viewer during volume adjustment and avoiding unnecessary adjustment during change of the input mode.

According to the above-described arrangement, the microcomputer reduces the audio control signal output from the audio control circuit and the drive voltage output from the power control circuit by the first step amount and the first voltage for both of which the viewer does not feel uncomfortable when the temperature of the control IC supplied by the temperature sensor has reached the set temperature immediately before which the thermal protector circuit incorporated in the control IC actuates. The microcomputer further re-monitors the temperature of the control IC for the predetermined time period and thereafter repeats a first control of reducing the audio control signal and the drive voltage by the second step amount and a second voltage respectively or returning the audio control signal and the drive voltage to the immediately preceding levels respectively depending upon whether the temperature of the control IC is at or above the set temperature and a second control of thereafter repeatedly monitoring the temperature of the control IC for the predetermined time period, thereby adjusting the audio control signal and the drive voltage step by step and displaying adjustment start information and adjustment completion information on a screen.

Furthermore, when the input mode has been changed, the audio control signal and the drive voltage are released from the adjustment control by the microcomputer and returned to the original values, and the adjustment completion information is displayed on the screen.

When the temperature of the control IC supplied from the temperature sensor has reached the set temperature immediately before the thermal protector circuit incorporated in the control IC is actuated, the microcomputer reduces the audio control signal output from the audio control circuit and the drive voltage output from the power control circuit by the first step amount and the first voltage both of which do not cause the viewer to feel uncomfortable, respectively, and thereafter re-monitors the temperature of the control IC for the predetermined time period. The microcomputer subsequently continuously repeats the first control of reducing the audio control signal and the drive voltage by the second step amount and the second voltage respectively or returning the audio control signal and the drive voltage to the immediately preceding levels respectively depending upon whether the temperature of the control IC is at or above the set temperature and a second control of thereafter repeatedly monitoring the temperature of the control IC for the predetermined time period, thereby adjusting the audio control signal and the drive voltage step by step and displaying adjustment start information and adjustment completion information on a screen.

Furthermore, when the input mode has been changed, the audio control signal and the drive voltage are released from the adjustment control by the microcomputer and returned to the original values, and the adjustment completion information is displayed on the screen.
Consequently, the television set can be provided in which the levels of the audio control signal output from the audio control circuit and the drive voltage output from the power control circuit are repeatedly adjusted step by step without actuation of the thermal protector circuit incorporated in the control IC which results in rapid sound reduction and reproduction, thereby reducing uncomfortableness of the viewer during the volume adjustment while preventing thermal destruction of the control IC. Furthermore, unnecessary adjustment can be avoided when the input mode is changed.

In one embodiment, an audio output device producing sound comprises an audio control circuit outputting to an audio amplifier an audio control signal generated based on a volume signal supplied from an audio adjustment switch, the audio amplifier amplifying an audio signal supplied thereto into an audio output signal with a predetermined volume based on the audio control signal supplied from the audio control circuit, the audio amplifier including a control IC, a power control circuit generating a predetermined drive voltage from a power supply voltage supplied thereto and supplying the generated drive voltage to the audio amplifier, and a microcomputer monitoring a temperature of the control IC of the audio amplifier and gradually reducing the audio control signal output from the audio control circuit and the drive voltage output from the power control circuit when the temperature of the control IC has reached a set temperature, the microcomputer gradually returning the audio control signal and the drive voltage to respective levels before reduction.

When the temperature of the control IC has reached the set temperature, the microcomputer reduces the audio control signal output from the audio control circuit and the drive voltage output from the power control circuit by the respective levels within a range in which the viewer does not feel uncomfortable and subsequently re-monitors the temperature of the control IC for the predetermined time period. The microcomputer subsequently continuously repeats a first control of further reducing the audio control signal and the drive voltage or returning the audio control signal and the drive voltage to the immediately preceding levels respectively depending upon whether the temperature of the control IC is at or above the set temperature and a second control of thereafter repeatedly monitoring the temperature of the control IC for the predetermined time period, thereby adjusting the audio control signal and the drive voltage step by step.

When the temperature of the control IC has reached the set temperature, the microcomputer reduces the audio control signal output from the audio control circuit and the drive voltage output from the power control circuit to the levels within the range in which the viewer does not feel uncomfortable and subsequently re-monitors the temperature of the control IC for the predetermined time period. The microcomputer subsequently continuously repeats the first control of further reducing the audio control signal and the drive voltage or returning the audio control signal and the drive voltage to the immediately preceding levels respectively depending upon whether the temperature of the control IC is at or above the set temperature and the second control of thereafter repeatedly monitoring the temperature of the control IC for the predetermined time period, thereby adjusting the audio control signal and the drive voltage step by step.

Consequently, the audio output device can be provided in which the levels of the audio control signal output from the audio control circuit and the drive voltage output from the power control circuit are repeatedly adjusted step by step without actuation of the thermal protector circuit incorporated in the control IC which results in rapid sound reduction and reproduction, thereby reducing uncomfortableness of the viewer during the volume adjustment while preventing thermal destruction of the control IC.

When the temperature of the control IC has reached the set temperature, the microcomputer reduces the audio control signal output from the audio control circuit and the drive voltage output from the power control circuit by the first step amount and the first voltage for which the viewer does not feel uncomfortable and subsequently re-monitors the temperature of the control IC for the predetermined time period. The microcomputer subsequently continuously repeats the first control of reducing the audio control signal and the drive voltage by the second step amount and the second voltage depending upon whether the temperature of the control IC is at or above the set temperature or returning the levels of the audio control signal and the drive voltage to the respective immediately preceding levels and the second control of thereafter monitoring the temperature of the control IC for the predetermined time period, thereby adjusting the audio control signal and the drive voltage step by step.

Consequently, the audio output device can be provided in which the levels of the audio control signal output from the audio control circuit and the drive voltage output from the power control circuit are repeatedly adjusted step by step without actuation of the thermal protector circuit incorporated in the control IC which results in rapid sound reduction and reproduction, thereby reducing uncomfortableness of the viewer during the volume adjustment while preventing thermal destruction of the control IC.

According to the above-described arrangement, the microcomputer reduces the audio control signal output from the audio control circuit and the drive voltage output from the power control circuit by the first step amount and the first voltage both of which do not cause the viewer to feel uncomfortable when the temperature of the control IC supplied by the temperature sensor has reached the set temperature immediately before which the thermal protector circuit incorporated in the control IC actuates. The microcomputer further re-monitors the temperature of the control IC for the predetermined time period and thereafter repeats a first control of reducing the audio control signal and the drive voltage by the second step amount and a second voltage respectively or returning the audio control signal and the drive voltage to the immediately preceding levels respectively depending upon whether the temperature of the control IC is at or above the set temperature and a second control of thereafter repeatedly monitoring the temperature of the control IC for the predetermined time period, thereby adjusting the audio control signal and the drive voltage step by step and displaying adjustment start information and adjustment completion information on a screen.

Consequently, the audio output device can be provided in which the levels of the audio control signal output from the audio control circuit and the drive voltage output from the power control circuit are repeatedly adjusted step by step without actuation of the thermal protector circuit incorporated in the control IC which results in rapid sound reduction and reproduction, thereby reducing uncomfortableness of the viewer during the volume adjustment while preventing thermal destruction of the control IC.

In further another embodiment, the audio output device is a television set which displays a predetermined image based on an image signal externally supplied thereto. The audio output device includes a tuner extracting a broadcast signal corresponding to a selected channel from a received television broadcast signal and outputting the extracted signal, a controller carrying out control processing for video, audio, power supply and the like, a remote controller for carrying out power on/off, channel selection, volume adjustment, change to external input and the like in a wireless manner, an audio processor controlled by the controller so that audio processing is carried out, an OSD circuit displaying information of sound volume, a channel, an input mode and the like on the display, and a loud speaker producing sound based on audio output signal supplied from the audio processor. The audio processor includes an audio control circuit outputting an audio control signal based on a volume signal supplied from the remote controller or an audio adjustment switch equipped on a television body, an audio amplifier which carries out amplification into an audio output signal with a predetermined sound volume based on the audio control signal supplied from the audio control circuit, a power control circuit which controls an input power supply so that a predetermined drive voltage is arbitrarily obtained from the input power supply, outputting the obtained drive voltage to the audio amplifier, a microcomputer adjusting the audio control signal delivered from the audio control circuit and the drive voltage delivered from the power control circuit into respective predetermined levels, and an EEPROM storing respective levels of the audio control signal delivered from the audio control circuit and the drive voltage delivered from the power control circuit before adjustment by the microcomputer. The audio amplifier includes a control IC incorporated with a thermal protector circuit which rapidly reduces the audio output signal delivered to the loud speaker when a temperature of an element is increased to a temperature having a possibility of thermal destruction, thereby protecting the element, the control IC having a package and a radiator plate, and a temperature sensor detecting a temperature of the package or the radiator plate of the control IC. The microcomputer causes the EEPROM to store respective levels of the audio control signal output from the audio control circuit and the drive voltage output from the power control circuit just when the temperature of the control IC has reached a set temperature having a value reached immediately before actuation of the thermal protector circuit.
The microcomputer reduces a level of the audio control signal output from the audio control circuit by a previously set first step amount that is a level at which a viewer does not feel uncomfortable and a level of the drive voltage output from the power control circuit by a previously set first voltage that is a level at which the viewer does not feel uncomfortable, the microcomputer thereafter controlling the OSD circuit to display adjustment start information on the display and monitoring for a predetermined time period as to whether the temperature of the control IC is increased to or above a set temperature which is equal to a value immediately before actuation of the thermal protector circuit. The microcomputer reads values of an initial audio control signal and an initial drive voltage before adjustment both stored on the EEPROM to return the audio control signal and the drive voltage to the respective initial levels. The microcomputer simultaneously controls the OSD circuit to display adjustment completion information on the display. The microcomputer reduces the drive voltage level by a second step amount smaller than the first step amount when the temperature of the control IC in not reduced below the set temperature. The microcomputer re-monitors for a predetermined time period as to whether the temperature of the control IC is increased to or above the set temperature which is equal to a value immediately before actuation of the thermal protector circuit. The microcomputer thereafter repeats a control of monitoring as to whether the temperature of the control IC is increased to or above the set temperature, a control of reducing the audio control signal and the drive voltage or returning the audio control signal and the drive voltage to the immediately preceding step amount and voltage and a control of thereafter monitoring the temperature of the control IC for a predetermined time period. The microcomputer controls the OSD circuit to display adjustment completion information on the display. The microcomputer consequently controls the OSD circuit to display the adjustment completion information on the display when the audio control signal and the drive voltage have been returned to the respective initial values before adjustment. The microcomputer returns the levels of the audio control signal output from the audio control circuit and the drive signal output from the power control circuit to the respective initial values before adjustment stored on the EEPROM and controlling the OSD circuit to display adjustment cancel information on the display, whereby the levels of the audio control signal output from the audio control circuit and the drive voltage output from the power control circuit are previously are repeatedly adjusted step by step without actuation of the thermal protector circuit incorporated in the control IC, thereby reducing uncomfortableness of the viewer during volume adjustment and avoiding unnecessary adjustment during change of the input mode.

Consequently, the audio output device can be provided in which the levels of the audio control signal output from the audio control circuit and the drive voltage output from the power control circuit are repeatedly adjusted step by step without actuation of the thermal protector circuit incorporated in the control IC which results in rapid sound reduction and reproduction, thereby reducing uncomfortableness of the viewer during the volume adjustment while preventing thermal destruction of the control IC.

According to the foregoing arrangement, when the input mode has been changed, the audio control signal and the drive voltage are released from the adjusting control by the microcomputer. The audio control signal and the drive voltage are returned to the respective original values and adjustment release information is displayed.

Consequently, the audio output device can be provided which can avoid unnecessary adjustment during change of the input mode.

Consequently, the same effect as described above can be achieved from the flowchart.

These and other features, aspects, and advantages of the invention will be apparent to those skilled in the art from the following detailed description of preferred non-limiting exemplary embodiments, taken together with the drawings and the claims that follow.

### Brief Description of the Drawings

It is to be understood that the drawings are to be used for the purposes of exemplary illustration only and not as a definition of the limits of the invention. Throughout the disclosure, the word "exemplary" is used exclusively to mean "serving as an example, instance, or illustration." Any embodiment described as "exemplary" is not necessarily to be construed as preferred or advantageous over other embodiments.
Referring to the drawings in which like reference character(s) present corresponding parts throughout:

FIG. 1 is a block diagram showing an electrical arrangement of a plasma television set of one embodiment of the invention;
FIG. 2 is also a block diagram showing another electrical arrangement of the plasma television set;
FIG 3 is also a block diagram showing further another electrical arrangement of the plasma television set;
FIGS. 4A and 4B are flowcharts showing a control manner of a microcomputer; and
FIG. 5 is a block diagram showing a conventional arrangement.

### Description of Special Embodiments

The detailed description set forth below in connection with the appended drawings is intended as a description of presently preferred embodiments of the invention and is not intended to represent the only forms in which the present invention may be constructed and or utilized.
For purposes of illustration, programs and other executable program components are illustrated herein as discrete blocks, although it is recognized that such programs and components may reside at various times in different storage components, and are executed by the data processor(s) of the computers.

One embodiment of the present invention will be described with reference to the accompanying drawings. The invention is applied to an audio output device and a plasma television set as a television set in the embodiment.

### [Embodiment 1]

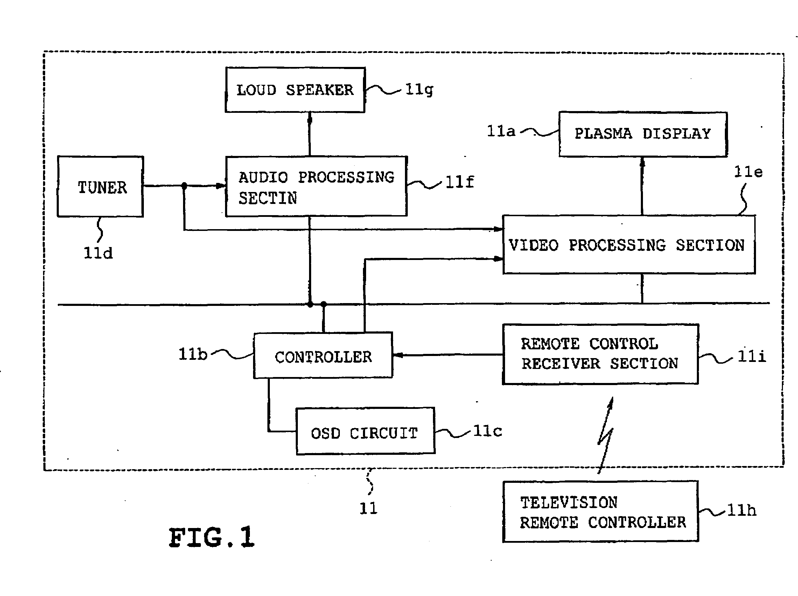

FIG. 1 is a block diagram showing a schematic electrical arrangement of the plasma television set 11 of the embodiment. Detailed description and drawings of the structure of the plasma television set 11 which has no direct relation with the invention will be eliminated.

In FIG. 1, the plasma television set 11 comprises a plasma display 11a, a controller which controls the operation of plasma television body, a tuner 11d which extracts an television broadcast signal for a selected channel from television broadcast signals received by an antenna (not shown) and outputting the extracted signals, a video processing section 11e which displays on the plasma display 11a an image based on the television broadcast signal output from the tuner 11d or an externally supplied image signal, an audio processor 11f producing from a loud speaker 11g sound based on the television broadcast signal delivered from the tuner 11d or an externally supplied audio signal, a remote controller 11h which carries out power on/off, channel selection, sound volume adjustment, change to external input and the like in a wireless manner, a remote control receiving section 11i which receives a control command transmitted from the remote controller 11h, and an on screen display (OSD) 11c displaying various pieces of information such as sound volume, channel and an input mode on the display.

The controller 11b controls on/off of power supply, channel change, up/down of sound volume and the like according to a control command received by the remote control receiving section 11i. Operating power is supplied from a power supply circuit (not shown) to various sections of the plasma television set 11. The power supply circuit is connected to a commercial power supply (AC 100 V, for example).

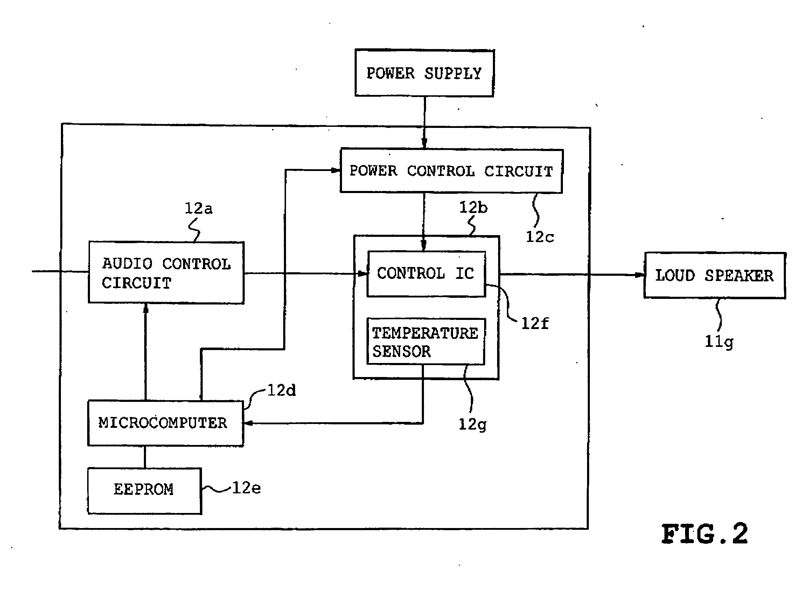

Referring to FIG 2, the audio processor 11f includes an audio control circuit 12a which delivers an audio control signal based on a sound volume signal supplied thereto from an audio adjustment switch provided on the television body or from the remote controller 11h, an audio amplifier 12b which amplifies the audio control signal into an audio output signal with a predetermined sound volume and deliver the audio output signal to the loud speaker 11g, a power control circuit 12c, a microcomputer 12d which adjusts the audio control signal output from the audio control circuit 12a and the drive voltage output from the power control circuit 12c to respective predetermined levels, and an EEPROM 12e storing levels of the audio control signal output from the audio control circuit 12a and the drive voltage output from the power control circuit 12c before level adjustment by the microcomputer 12d.

The audio amplifier 12b comprises a control IC 12f and a temperature sensor 12g detecting a temperature of a package or a radiator plate of the control IC 12f. The control IC 12f comprises integrated circuit (IC) elements die-bonded to the radiator plate and wire-bonded to a connection terminal and then resin-molded and then mounted on a substrate. Heat generated during amplification of the audio control signal into the audio output signal is dissipated by the radiator plate so that temperature rise of the IC elements is suppressed.

However, when the viewer watches the TV with a larger sound volume, an amount of heat generated by the IC element is increased such that heat radiation by the radiator plate becomes insufficient. As a result, since the temperature of the IC element rises, there is a possibility that the IC element may thermally be destructed. In view of this problem, the control IC 12f is incorporated with a thermal protector circuit for preventing the aforementioned thermal destruction. The thermal protector circuit detects a temperature of the IC element and rapidly reduces an audio signal delivered to the loud speaker 11g by a large amount when the detected temperature has reached a predetermined temperature at which thermal destruction occurs, thereby dropping the temperature of the IC element for protection of the same. When the detected temperature has dropped below the predetermined temperature, the thermal protector circuit restores the original audio output signal.

When the temperature of the control IC 12f detected by the temperature sensor 12g has reached a predetermined temperature immediately before actuation of the thermally protector circuit, the microcomputer 12d causes the EEPROM 12e to store the levels of the audio control signal output from the audio control circuit 12a and the drive voltage output from the power control circuit 12c at that time. The microcomputer 12d further reduces the level of the audio control signal by a previously set first step amount that is a level for which viewers do not feel uncomfortable and the level of the drive voltage by a previously set first voltage that is a level for which viewers do not feel uncomfortable. Thereafter, the microcomputer 12d causes the OSD circuit 11c to display adjustment start information on the display.

That viewers do not feel uncomfortable means that a person does not aurally feel uncomfortable. More specifically, this means that a fluctuation intensity of psychological acoustic index has a level at which a person can aurally feel nothing.
For example, it is known that a person usually has a difficulty in feeling aural changes regarding changes up to decibel equivalent of 3 dB. Accordingly, the foregoing first step amount and first voltage are determined so that a sound volume changes within a range in which a person has a difficulty in feeling aural changes.

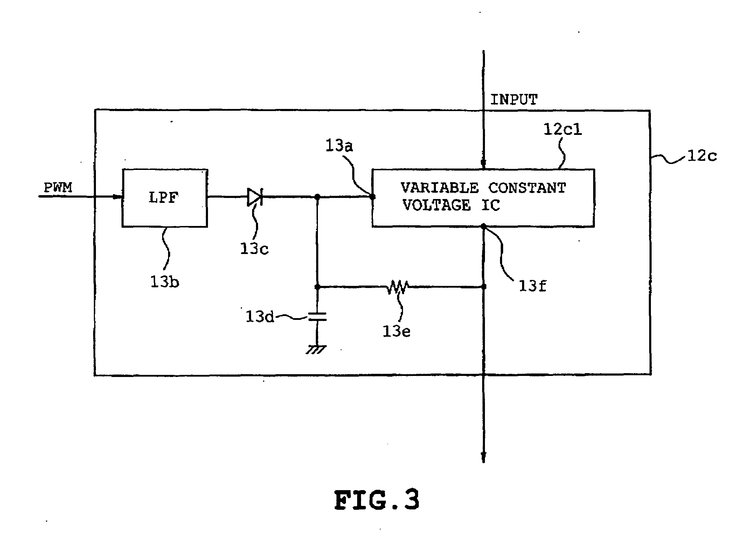

FIG. 3 is a circuit diagram explaining adjustment of the above-described drive voltage level output from the power control circuit 12c.

The microcomputer 12d supplies a PWM signal via a low-pass filter 13b and a rectifier diode 13c to a voltage control input terminal 13a of a variable constant voltage IC 12c1 composing the power control circuit 12c. A common node between the rectifier diode 13c and the voltage control input terminal 13a is grounded via a electrolytic capacitor 13d and connected via a resistance 13e to an output terminal 13f of the variable constant voltage IC 12c1.

Regarding the level adjustment of the drive voltage output from the power control circuit 12c, the PWM signal with a predetermined duty ratio is supplied from the microcomputer 12d to the power control circuit 12c. A lower frequency component of the PWM signal is rectified via the low-pass filter 13b and subsequently, the electrolytic capacitor 13d is charged. The electrolytic capacitor 13d repeats full charge and discharge, whereby the analog voltage is supplied to the voltage control terminal 13 a so that the level of drive voltage of the variable constant voltage IC 12c1 is adjusted based on he analog voltage.

The microcomputer 12d reduces the level of audio control signal output from the audio control circuit 12a by a previously set first step amount which is the level at which viewers do not feel uncomfortable. The microcomputer 12d further reduces the level of drive voltage output from the power control circuit 12c by a previously set first voltage which is the level at which viewers do not feel uncomfortable. Subsequently, the microcomputer 12d monitors the temperature of the control IC 12f supplied thereto from the temperature sensor 12g, for a predetermined time period as to whether the temperature is increased to or above a set temperature immediately before which the thermal protector circuit is actuated.

As a result, when the temperature of the control IC 12f is lower than the set temperature, the microcomputer 12d reads the initial values of audio control signal and drive voltage before adjustment from the EEPROM 12e to return the audio control signal and drive voltage to the respective initial values. The microcomputer 12d simultaneously controls the OSD circuit 11c to display adjustment completion information on the display 11a. On the other hand, when the temperature of the control IC 12f is equal to or higher than the set temperature, the microcomputer 12d reduces the audio control signal and the drive voltage by a second step amount that is smaller than the first step amount and by a second voltage that is smaller than the first voltage, respectively. The microcomputer 12d further re-monitors the temperature of the control IC 12f supplied thereto from the temperature sensor 12g, for a predetermined time period as to whether the temperature is increased to or above a set temperature immediately before which the thermal protector circuit is actuated.

Thereafter, the microcomputer 12d continuously repeats a first control of reducing the audio control signal and the drive voltage or returning the audio control signal and the drive voltage to the respective immediately preceding levels of step amount and voltage and a second control of thereafter monitoring the temperature of the control IC for a predetermined time period. Consequently, when the audio control signal and the drive voltage has returned to the initial values of the audio control signal and drive voltage before adjustment, the microcomputer 12d controls the OSD circuit 11c to display the adjustment completion information on the display 11a.

More specifically, when the temperature of the control IC 12f is equal to or higher than the set temperature, the microcomputer 12d reduces the level of the audio control signal by the first step amount which is the level at which the viewer does not feel uncomfortable and further reduces the level of the drive voltage by the first voltage which is the level at which the viewer does not feel uncomfortable. Consequently, there is no possibility that sound is interrupted as in the conventional television sets. Moreover, the OSD circuit is controlled so as to display the adjustment start information and the adjustment completion information on the display 11a, whereby the viewer is notified that adjustment control is being carried out. Consequently, the viewer's uncomfortableness can be reduced.

Furthermore, when the temperature of the control IC 12f is equal to or higher than the set value, the microcomputer 12d reduces the drive voltage as well as the audio control signal which is conventionally reduced. Accordingly, the temperature of the control IC 12f can be reduced quickly. As a result, the control IC can be protected against thermal destruction more reliably even when an amount of heat generated is enormously large such as the case where a viewer watches the TV with a large sound volume.

Furthermore, the second step amount and the second voltage are set at smaller values than the first step amount and the second voltage respectively. Accordingly, for example, even when the temperature of the control IC 12f is additionally reduced after not having been rendered lower than the set temperature by the reduction of the first step amount and the first voltage, smaller step amount and smaller voltage are applied such that the viewer's uncomfortableness can be reduced.

Consider now a case where an input mode has been changed between an internal input mode and an external input mode by the remote controller 11h or the external input change switch during adjustment of the values of the audio control signal and the drive voltage by the above-described adjustment control. In this case, the microcomputer 12d returns the levels of the audio control signal output from the audio control circuit 12a and the drive voltage output from the power control circuit 12c to the respective initial levels before adjustment the data of which is stored on the EEPROM 12e. Furthermore, the microcomputer 12d controls the OSD circuit 11c to display the adjustment completion information on the display 11a.

Consequently, the adjustment control is interrupted when the input mode has been changed and accordingly the adjustment control need not be carried out. As a result, unnecessary adjustment can be avoided.

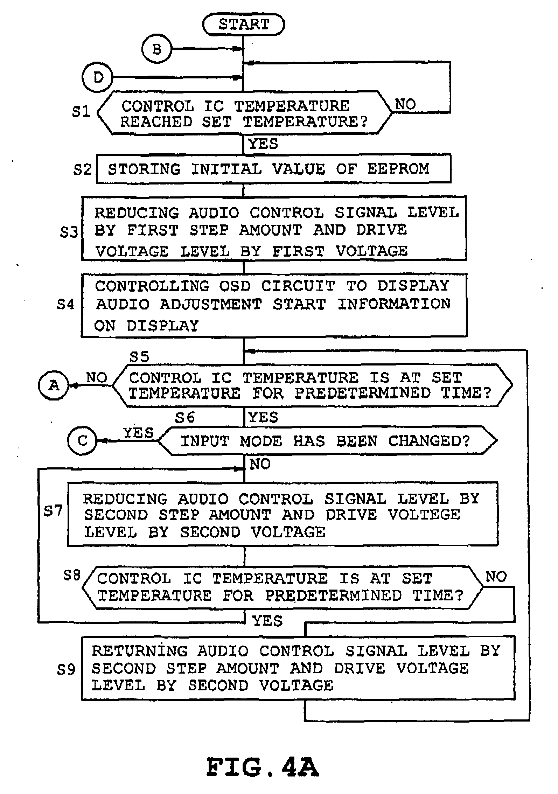

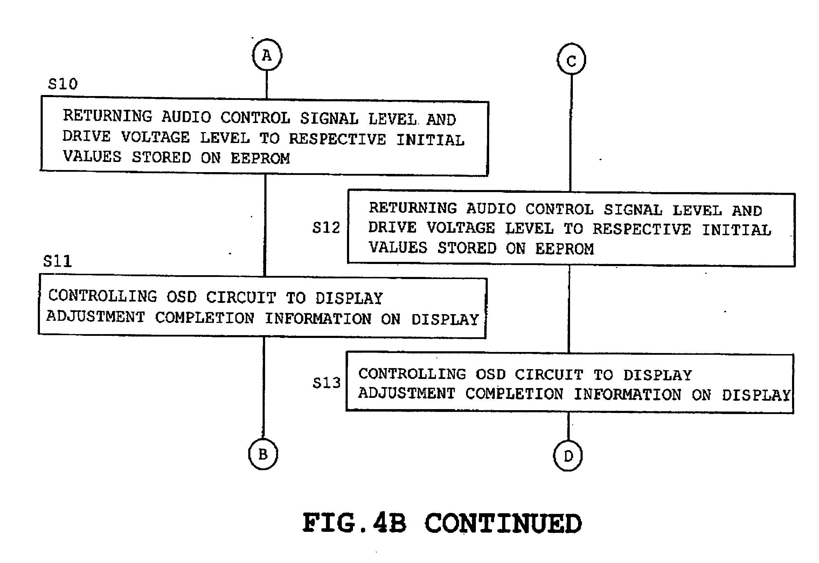

The foregoing adjustment control of the audio control signal and the drive voltage by the microcomputer 12d will now be described with reference to the flowchart of FIG 4.

More specifically, the microcomputer 12d determines, at step 1, whether the temperature of the audio control circuit 12a has reached the set temperature. When the temperature of the audio control circuit 12a has reached the set temperature, the microcomputer 12d advances to step 2. On the other hand, when the temperature of the audio control circuit 12a has not reached the set temperature, the microcomputer 12d repeats the determination.

At step 2, the microcomputer 12d stores the initial values of the audio control signal and the drive voltage on the EEPROM 12e, advancing to step 3.

At step 3, the microcomputer 12d reduces the levels of the audio control signal and the drive voltage by the first step amount and first voltage respectively, advancing to step 4.

At step 4, the microcomputer 12d causes the OSD circuit 11c to display the audio adjustment start information on the display 11a, advancing to step 5.

At step 5, the microcomputer 12d monitors the temperature of the control IC 12f for the set time period to determine whether the control IC 12f has reached the set temperature. The microcomputer 12d advances to step 6 when the control IC 12f has reached the set temperature. On the other hand, the microcomputer 12d advances to step 10 when the control IC 12f has not reached the set temperature.

At step 6, the microcomputer 12d determines whether the input mode has been changed between the internal input and the external input. The microcomputer 12d advances to step 12 when the input mode has been changed between the internal input and the external input. On the other hand, the microcomputer 12d advances to step 7 when the input mode has not been changed between the internal input and the external input.

At step 7, the microcomputer 12d reduces the levels of the audio control signal and the drive voltage by the second step amount and the second voltage respectively, advancing to step 8.

At step 8, the microcomputer 12d monitors the temperature of the control IC 12f for the predetermined time period to determine whether the control IC 12f has reached the set temperature. The microcomputer 12d advances to step 7 when the control IC 12f has reached the set temperature. On the other hand, the microcomputer 12d advances to step 9 when the control IC 12f has not reached the set temperature.

At step 9, the microcomputer 12d returns the levels of the audio control signal and the drive voltage by the second step amount and the second voltage respectively, advancing to step 5.

At step 10, the microcomputer 12d returns the levels of the audio control signal and the drive voltage to the respective initial values stored on the EEPROM 12e, advancing to step 11.

At step 11, the microcomputer 12d causes the OSD circuit 11c to display the audio adjustment start information on the display 11a, advancing to step 1.

At step 12, the microcomputer 12d returns the levels of the audio control signal and the drive voltage to the respective initial values stored on the EEPROM 12e, advancing to step 13.

At step 13, the microcomputer 12d causes the OSD circuit 11c to display the audio adjustment interrupt information on the display 11a, advancing to step 1.

When the microcomputer 12d carries out the adjustment control of the audio control signal output from the audio control circuit 12a and the drive voltage output from the power control circuit 12c according to the flowchart, the television set can be provided in which the levels of the audio control signal output from the audio control circuit 12a and the drive voltage output from the power control circuit 12c are repeatedly adjusted step by step without actuation of the thermal protector circuit incorporated in the control IC which results in rapid sound reduction and reproduction, thereby reducing uncomfortableness of the viewer during the volume adjustment while preventing thermal destruction of the control IC 12f Furthermore, unnecessary adjustment can be avoided when the input mode is changed.

The present invention should not be limited to the arrangement of the embodiment but the embodiment may be modified as follows:

1. Although the plasma television set is exemplified as the audio output device in the foregoing embodiment, the invention may be applied to various other apparatus or devices from which sound or voice is produced such as any thin screen television set other than the plasma television set, CRT television sets, audio apparatus or devices.

2. Although the configuration of displaying adjustment information on the display by the OSD circuit is described as an audio adjustment display device, the information may be displayed by lamps such as LEDs, for example.

Furthermore, the audio adjustment display device may be eliminated. In this case, although adjustment display cannot be carried out for the viewer, the effect of preventing the control IC from thermal destruction without uncomfortableness of the viewer can be achieved reliably.

3. In the foregoing embodiment, the adjustment control is interrupted when the input mode has been changed such that the adjustment control is no longer necessary. This function may be eliminated. In this case, although unnecessary adjustment control cannot be prevented when the input mode has been changed, the effect of preventing the control 1C from thermal destruction without uncomfortableness of the viewer can be achieved reliably.

4. Although the control IC is employed as the audio amplifier in the foregoing embodiment, the audio amplifier may comprise, for example, a wiring circuit board.

5. Although the temperature of the control IC is detected by the temperature sensor in the foregoing embodiment, a circuit for detecting the temperature may be incorporated in the element of the control IC, for example.

6. Although second or subsequent amounts of reduction by which the audio control signal and the drive voltage are adjusted are fixed to the second step amount and second voltage in the foregoing embodiment, the amount of reduction may be variable so as to be reduced every time the audio control signal and the drive voltage. In this case, the uncomfortableness of the viewer can further be reduced.

The operations of claim 3 and subsequent claims will be described.

In another embodiment, an amount of step by which the audio control signal the audio control circuit delivers based on the temperature of the control IC and the voltage by which the power control circuit delivers based on the temperature of the control IC include a first step amount and a first voltage which reduce the audio control signal and the voltage to both initial values before adjustment and a second step amount and a second voltage both delivered subsequently to the first step amount and the first voltage, the second step amount and the second voltage being set to be smaller than the first step amount and the first voltage respectively.

When the temperature of the control IC has reached the set temperature, the microcomputer reduces the audio control signal output from the audio control circuit and the drive voltage output from the power control circuit by the first step amount and the first voltage for which the viewer does not feel uncomfortable and subsequently re-monitors the temperature of the control IC for the predetermined time period. The microcomputer subsequently continuously repeats the first control of reducing the audio control signal and the drive voltage by the second step amount and the second voltage depending upon whether the temperature of the control IC is at or above the set temperature or returning the levels of the audio control signal and the drive voltage to the respective immediately preceding levels and the second control of thereafter monitoring the temperature of the control IC for the predetermined time period, thereby adjusting the audio control signal and the drive voltage step by step.

In further another embodiment, the audio output device further comprises an audio adjustment display unit which displays start and completion of an adjustment control of the audio control signal output from the audio control circuit and the drive voltage output from the power control circuit, the adjustment control being carried out by the control IC on the basis of the temperature of the control IC.

According to the above-described arrangement, the microcomputer reduces the audio control signal output from the audio control circuit and the drive voltage output from the power control circuit by the first step amount and the first voltage both of which do not cause the viewer to feel uncomfortable when the temperature of the control IC supplied by the temperature sensor has reached the set temperature immediately before which the thermal protector circuit incorporated in the control IC actuates. The microcomputer further re-monitors the temperature of the control IC for the predetermined time period and thereafter repeats a first control of reducing the audio control signal and the drive voltage by the second step amount and a second voltage respectively or returning the audio control signal and the drive voltage to the immediately preceding levels respectively depending upon whether the temperature of the control IC is at or above the set temperature and a second control of thereafter repeatedly monitoring the temperature of the control IC for the predetermined time period, thereby adjusting the audio control signal and the drive voltage step by step and displaying adjustment start information and adjustment completion information on a screen.

In further another embodiment, the audio output device is a television set which displays a predetermined image based on an image signal externally supplied thereto. The audio output device includes a tuner extracting a broadcast signal corresponding to a selected channel from a received television broadcast signal and outputting the extracted signal, a controller carrying out control processing for video, audio, power supply and the like, a remote controller for carrying out power on/off, channel selection, volume adjustment, change to external input and the like in a wireless manner, an audio processor controlled by the controller so that audio processing is carried out, an OSD circuit displaying information of sound volume, a channel, an input mode and the like on the display, and a loud speaker producing sound based on audio output signal supplied from the audio processor. The audio processor includes an audio control circuit outputting an audio control signal based on a volume signal supplied from the remote controller or an audio adjustment switch equipped on a television body, an audio amplifier which carries out amplification into an audio output signal with a predetermined sound volume based on the audio control signal supplied from the audio control circuit, a power control circuit which controls an input power supply so that a predetermined drive voltage is arbitrarily obtained from the input power supply, outputting the obtained drive voltage to the audio amplifier, a microcomputer adjusting the audio control signal delivered from the audio control circuit and the drive voltage delivered from the power control circuit into respective predetermined levels, and an EEPROM storing respective levels of the audio control signal delivered from the audio control circuit and the drive voltage delivered from the power control circuit before adjustment by the microcomputer. The audio amplifier includes a control IC incorporated with a thermal protector circuit which rapidly reduces the audio output signal delivered to the loud speaker when a temperature of an element is increased to a temperature having a possibility of thermal destruction, thereby protecting the element, the control IC having a package and a radiator plate, and a temperature sensor detecting a temperature of the package or the radiator plate of the control IC. The microcomputer causes the EEPROM to store respective levels of the audio control signal output from the audio control circuit and the drive voltage output from the power control circuit just when the temperature of the control IC has reached a set temperature having a value reached immediately before actuation of the thermal protector circuit. The microcomputer reduces a level of the audio control signal output from the audio control circuit by a previously set first step amount that is a level at which a viewer does not feel uncomfortable and a level of the drive voltage output from the power control circuit by a previously set first voltage that is a level at which the viewer does not feel uncomfortable, the microcomputer thereafter controlling the OSD circuit to display adjustment start information on the display and monitoring for a predetermined time period as to whether the temperature of the control IC is increased to or above a set temperature which is equal to a value immediately before actuation of the thermal protector circuit. The microcomputer reads values of an initial audio control signal and an initial drive voltage before adjustment both stored on the EEPROM to return the audio control signal and the drive voltage to the respective initial levels. The microcomputer simultaneously controls the OSD circuit to display adjustment completion information on the display. The microcomputer reduces the drive voltage level by a second step amount smaller than the first step amount when the temperature of the control IC in not reduced below the set temperature. The microcomputer re-monitors for a predetermined time period as to whether the temperature of the control IC is increased to or above the set temperature which is equal to a value immediately before actuation of the thermal protector circuit. The microcomputer thereafter repeats a control of monitoring as to whether the temperature of the control IC is increased to or above the set temperature, a control of reducing the audio control signal and the drive voltage or returning the audio control signal and the drive voltage to the immediately preceding step amount and voltage and a control of thereafter monitoring the temperature of the control IC for a predetermined time period. The microcomputer controls the OSD circuit to display adjustment completion information on the display. The microcomputer consequently controls the OSD circuit to display the adjustment completion information on the display when the audio control signal and the drive voltage have been returned to the respective initial values before adjustment. The microcomputer returns the levels of the audio control signal output from the audio control circuit and the drive signal output from the power control circuit to the respective initial values before adjustment stored on the EEPROM and controlling the OSD circuit to display adjustment cancel information on the display, whereby the levels of the audio control signal output from the audio control circuit and the drive voltage output from the power control circuit are previously are repeatedly adjusted step by step without actuation of the thermal protector circuit incorporated in the control IC, thereby reducing uncomfortableness of the viewer during volume adjustment and avoiding unnecessary adjustment during change of the input mode.

According to the above-described arrangement, the microcomputer reduces the audio control signal output from the audio control circuit and the drive voltage output from the power control circuit by the first step amount and the first voltage for both of which the viewer does not feel uncomfortable when the temperature of the control IC supplied by the temperature sensor has reached the set temperature immediately before which the thermal protector circuit incorporated in the control IC actuates. The microcomputer further re-monitors the temperature of the control IC for the predetermined time period and thereafter continuously repeats the first control of reducing the audio control signal and the drive voltage by the second step amount or second voltage or returning the audio control signal and the drive voltage to the immediately preceding levels, respectively, and a second control of thereafter monitoring the temperature of the control IC for the predetermined time period, thereby adjusting the audio control signal and the drive voltage step by step. The microcomputer further displays the adjustment start information and adjustment completion information on a screen.

In further another embodiment, when an input mode is changed between an internal input by the tuner and an external input by operation of the remote controller or an external input change switch during the adjustment control of the audio control signal previously output from the audio control circuit and the drive voltage output from the power control circuit, the adjustment control being carried out on the basis of the temperature of the control IC, the microcomputer returns levels of the audio control signal output from the audio control circuit and the drive voltage to initial values before the adjustment, the data of which is stored on the EEPROM, respectively, whereby unnecessary adjustment during change in the input mode is avoided.

According to the above-described arrangement, when the input mode has been changed, the audio control signal and the drive voltage are released from the adjusting control by the microcomputer. The audio control signal and the drive voltage are returned to the respective original values and adjustment release information is displayed.

In further another embodiment, in the audio output device which produces voice and has a microcomputer, the microcomputer repeatedly adjusts the levels of the audio control signal previously output from the audio control circuit and the drive voltage output from power control circuit step by step without actuation of a thermal protector circuit according to a flowchart without actuation of a thermal protector circuit incorporated in the control IC, thereby reducing uncomfortableness a viewer feels during volume adjustment and avoiding unnecessary adjustment during change in an input mode, the flowchart including (1) a first step of determining whether a temperature of the control IC has reached a set temperature and advancing to a second step when the temperature of the control IC has reached the set temperature and advancing to a second step, whereas repeating the determination when the temperature of the control IC has not reached the set temperature; (2) the second step of storing on an EEPROM an initial value of the audio control signal and an initial value of the drive voltage and advancing to a third step; (3) the third step of reducing the level of the audio control signal by a first step amount and reducing the drive voltage by a first voltage and advancing to a fourth step; (4) the fourth step of displaying audio adjustment start information on a display and advancing to a fifth step; (5) the fifth step of monitoring the temperature of the control IC for a predetermined time period thereby to determine whether the temperature of the control IC has reached the set temperature, advancing to a sixth step when the temperature of the control IC has reached the set temperature, whereas advancing to a tenth step when the temperature of the control IC has not reached the set temperature; (6) a sixth step of determining whether the input mode has been changed between an internal input and an external input and, advancing to a twelfth step when the input mode has been changed, whereas advancing to a seventh step when the input mode has not been changed; (7) a seventh step of reducing the level of the audio control signal by a second step amount and reducing the drive voltage by a second voltage and thereafter advancing to an eighth step; (8) the eighth step of monitoring the temperature of the control IC for a predetermined time period thereby to determine whether the temperature of the control IC has reached the set temperature, advancing to the seventh step when the temperature of the control IC has reached the set temperature, whereas advancing to a ninth step when the temperature of the control IC has not reached the set temperature; (9) the ninth step of returning the level of the audio control signal by a second step and simultaneously returning the level of the drive voltage by a second voltage and advancing to the fifth step; (10) the tenth step of returning the levels of the audio control signal and the drive voltage to the initial values stored on the EEPROM respectively and advancing to an eleventh step; (11) the eleventh step of displaying audio adjustment completion information on the display by the OSD circuit and advancing to the first step; (12) the twelfth step of returning the levels of the audio control signal and the drive voltage to the initial values stored on the EEPROM respectively and advancing to a thirteenth step; and (13) the thirteenth step of displaying audio adjustment interrupt information on the display by the OSD circuit and advancing to the first step. Consequently, the audio output device can be provided which can avoid unnecessary adjustment during change of the input mode.

According to the above-described arrangement, the same effect as described above can be achieved from the flowchart.

While the invention has been particularly shown and described with respect to preferred embodiments thereof, it should be understood by those skilled in the art that the foregoing and other changes in form and detail may be made therein without departing from the sprit and scope of the invention as defined in the appended claims.

Although the invention has been described in considerable detail in language specific to structural features and or method acts, it is to be understood that the invention defined in the appended claims is not necessarily limited to the specific features or acts described. Rather, the specific features and acts are disclosed as preferred forms of implementing the claimed invention. Therefore, while exemplary illustrative embodiments of the invention have been described, numerous variations and alternative embodiments will occur to those skilled in the art.
It should further be noted that throughout the entire disclosure, the labels such as left, right, front, back, top, bottom, forward, reverse, clockwise, counter clockwise, up, down, or other similar terms such as upper, lower, aft, fore, vertical, horizontal, proximal, distal, etc. have been used for convenience purposes only and are not intended to imply any particular fixed direction or orientation. Instead, they are used to reflect relative locations and/or dixections/orientations between various portions of an object.
In addition, reference to "first," "second," "third," and etc. members throughout the disclosure (and in particular, claims) is not used to show a serial or numerical limitation but instead is used to distinguish or identify the various members of the group.

## Claims

1. A television set, comprising:
a display for displaying an image based on an externally supplied image signal on a screen of the display;
a tuner extracting a broadcast signal corresponding to a selected channel from a received television broadcast signal and outputting the extracted signal;
a controller carrying out control for video, audio, power supply;
a remote controller for carrying out power on/off, channel selection, volume adjustment, change to external input;
an audio processor processing audio in accordance with a control of the controller;
an on-screen-display (OSD) circuit displaying information of sound volume, a channel and an input mode on the display; and
a speaker producing sound based on audio output signal input from the audio processor, **characterized in that** the television set further comprises:
the audio processor including:
an audio control circuit outputting an audio control signal based on a volume signal supplied from the remote controller;
an audio amplifier amplifying an audio output signal in accordance with the audio control signal supplied from the audio control circuit;
a power control circuit that controls an input power supply so that a predetermined drive voltage is generated from the input power supply, outputting the obtained drive voltage to the audio amplifier;
a microcomputer adjusting the audio control signal output from the audio control circuit and the drive voltage output from the power control circuit into respective predetermined levels; and
an electrically erasable programmable read-only memory (EEPROM) storing respective levels of the audio control signal output from the audio control circuit and the drive voltage output from the power control circuit before adjustment by the microcomputer,
the audio amplifier including:
a control integrated circuit (IC) incorporated with a thermal protector circuit that rapidly reduces the audio output signal output to the loud speaker when a temperature of the control IC is increased to a temperature having a possibility of thermal destruction, thereby protecting the control IC; and a temperature sensor detecting a temperature of the control IC,
the microcomputer causing the EEPROM to store respective levels of the audio control signal output from the audio control circuit and the drive voltage output from the power control circuit when the temperature of the control IC has reached a set temperature having a value reached immediately before actuation of the thermal protector circuit,
the microcomputer reducing a level of the audio control signal output from the audio control circuit by a predetermined first step amount that is a level at which a viewer feel comfortable and a level of the drive voltage output from the power control circuit by a predetermined first voltage that is a level at which the viewer feel comfortable, the microcomputer thereafter controlling the OSD circuit to display adjustment start information on the display and monitoring for a predetermined time period as to whether the temperature of the control IC is increased to or above the set temperature that is equal to a value immediately before actuation of the thermal protector circuit, the microcomputer reading values of the audio control signal and the drive voltage both stored on the EEPROM to return the audio control signal and the drive voltage to the respective levels the adjustment is begun, the microcomputer simultaneously controlling the OSD circuit to display adjustment completion information on the display, the microcomputer reducing the audio control signal by a second step amount smaller than the first step amount and the microcomputer reducing the drive voltage level by a second voltage smaller than the predetermined first voltage when the temperature of the control IC is not reduced below the set temperature, the microcomputer re-monitoring for a predetermined time period as to whether the temperature of the control IC is increased to or above the set temperature that is equal to a value immediately before actuation of the thermal protector circuit, the microcomputer thereafter repeating a control of monitoring as to whether the temperature of the control IC is increased to or above the set temperature, a control of reducing the audio control signal and the drive voltage or returning the audio control signal and the drive voltage to the immediately preceding step amount and voltage and a control of thereafter monitoring the temperature of the control IC for a predetermined time period, the microcomputer consequently controlling the OSD circuit to display the adjustment completion information on the display when the audio control signal and the drive voltage have been returned to the respective values before the adjustment is begun, and the microcomputer returning the levels of the audio control signal output from the audio control circuit and the drive voltage output from the power control circuit to the respective values before the adjustment is begun that is stored on the EEPROM and controlling the OSD circuit to display adjustment cancel information on the display when an image signal input mode has been changed between an internal input mode and an external input mode by the remote controller or an external input change switch during adjustment of the values of the audio control signal and the drive voltage,
whereby the levels of the audio control signal output from the audio control circuit and the drive voltage output from the power control circuit are repeatedly adjusted step by step without actuation of the thermal protector circuit incorporated in the control IC, thereby avoiding the thermal destruction of the control IC, reducing uncomfortableness of the viewer during volume adjustment and avoiding unnecessary adjustment during change of the image signal input mode.

2. An audio output device producing sound, comprising:
an audio control circuit outputting to an audio amplifier an audio control signal generated based on a volume signal input from an audio adjustment switch;
the audio amplifier amplifying an audio input signal and outputting an audio output signal with a predetermined volume based on the audio control signal input from the audio control circuit, the audio amplifier including a control integrated circuit (IC);
a power control circuit generating a predetermined drive voltage from a power supply voltage input thereto and output the generated drive voltage to the audio amplifier; **characterized in that** the television set further comprises:
a microcomputer monitoring a temperature of the control IC of the audio amplifier and gradually reducing the audio control signal output from the audio control circuit and the drive voltage output from the power control circuit when the temperature of the control IC has reached a set temperature, the microcomputer gradually returning the audio control signal and the drive voltage to respective previous levels.

3. The audio output device according to claim 2, wherein an amount of step by which the audio control signal that is output from the audio control circuit decrease based on the temperature of the control IC and the voltage by which the power control circuit decrease based on the temperature of the control IC include a first step amount and a first voltage that reduce the audio control signal and the voltage to both initial values before the adjustment is begun and a second step amount and a second voltage both delivered subsequently to the first step amount and the first voltage, the second step amount and the second voltage being are smaller than the first step amount and the first voltage respectively.

4. The audio output device according to claim 2 or 3, further comprising an audio adjustment display unit that displays start and completion of an adjustment control of the audio control signal and the drive voltage, the adjustment control being carried out by the control IC based on the temperature of the control IC.

5. The audio output device according to claim 4, wherein the audio output device is a television set that displaying an image based on an externally supplied image signal on a screen of the display, the audio output device including:
a tuner extracting a broadcast signal corresponding to a selected channel from a received television broadcast signal and outputting the extracted signal;
a controller carrying out control processing for video, audio, power supply and the like;
a remote controller for carrying out power on/off, channel selection, volume adjustment, change to external input;
an audio processor processing audio in accordance with a control of the controller;
an on-screen-display (OSD) circuit displaying information of sound volume, a channel and an input mode on the display; and
a speaker producing sound based on audio output signal input from the audio processor,
the audio processor including:
an audio control circuit outputting an audio control signal based on a volume signal supplied from the remote controller;
an audio amplifier amplifying an audio output signal in accordance with the audio control signal supplied from the audio control circuit;
a power control circuit that controls an input power supply so that a predetermined drive voltage is generated from the input power supply, outputting the obtained drive voltage to the audio amplifier;
a microcomputer adjusting the audio control signal delivered from the audio control circuit and the drive voltage output from the power control circuit into respective predetermined levels; and
an electrically erasable programmable read-only memory (EEPROM) storing respective levels of the audio control signal output from the audio control circuit and the drive voltage output from the power control circuit before adjustment by the microcomputer,
the audio amplifier including:
a control integrated circuit (IC) incorporated with a thermal protector circuit that rapidly reduces the audio output signal output to the loud speaker when a temperature of the control IC is increased to a temperature having a possibility of thermal destruction, thereby protecting the control IC,; and a temperature sensor detecting a temperature of the control IC,
the microcomputer causing the EEPROM to store respective levels of the audio control signal output from the audio control circuit and the drive voltage output from the power control circuit when the temperature of the control IC has reached a set temperature having a value reached immediately before actuation of the thermal protector circuit,
the microcomputer reducing a level of the audio control signal output from the audio control circuit by a predetermined first step amount that is a level at which a viewer feel comfortable and a level of the drive voltage output from the power control circuit by a previously set first voltage that is a level at which the viewer feel comfortable, the microcomputer thereafter controlling the OSD circuit to display adjustment start information on the display and monitoring for a predetermined time period as to whether the temperature of the control IC is increased to or above the set temperature that is equal to a value immediately before actuation of the thermal protector circuit, the microcomputer reading values of the audio control signal and the drive voltage both stored on the EEPROM to return the audio control signal and the drive voltage to the respective levels the adjustment is begun, the microcomputer simultaneously controlling the OSD circuit to display adjustment completion information on the display, the microcomputer reducing the audio control signal by a second step amount smaller than the first step amount and the microcomputer reducing the drive voltage level by a second voltage smaller than the predetermined first voltage when the temperature of the control IC is not reduced below the set temperature, the microcomputer re-monitoring for a predetermined time period as to whether the temperature of the control IC is increased to or above the set temperature that is equal to a value immediately before actuation of the thermal protector circuit, the microcomputer thereafter repeating a control of monitoring as to whether the temperature of the control IC is increased to or above the set temperature, a control of reducing the audio control signal and the drive voltage or returning the audio control signal and the drive voltage to the immediately preceding step amount and voltage and a control of thereafter monitoring the temperature of the control IC for a predetermined time period, the microcomputer consequently controlling the OSD circuit to display the adjustment completion information on the display when the audio control signal and the drive voltage have been returned to the respective values before the adjustment is begun, and the microcomputer returning the levels of the audio control signal output from the audio control circuit and the drive voltage output from the power control circuit to the respective values before the adjustment is begun that is stored on the EEPROM and controlling the OSD circuit to display adjustment cancel information on the display when an image signal input mode has been changed between an internal input mode and an external input mode by the remote controller or an external input change switch during adjustment of the values of the audio control signal and the drive voltage,
whereby the levels of the audio control signal output from the audio control circuit and the drive voltage output from the power control circuit are repeatedly adjusted step by step without actuation of the thermal protector circuit incorporated in the control IC, thereby avoiding the thermal destruction of the control IC, reducing uncomfortableness of the viewer during volume adjustment and avoiding unnecessary adjustment during change of the image signal input mode.

6. The audio output device according to claim 4, wherein when an input mode is changed between an internal input by the tuner and an external input by operation of the remote controller or an external input change switch during the adjustment control of the audio control signal output from the audio control circuit and the drive voltage output from the power control circuit, the adjustment control being carried out on the basis of the temperature of the control IC, the microcomputer returns levels of the audio control signal output from the audio control circuit and the drive voltage to values before the adjustment, the data of which is stored on the EEPROM, respectively and the microcomputer control the OSD circuit to display adjustment cancel information on the display, whereby unnecessary adjustment during change in the input mode is avoided.

7. The audio output device according to claim 6, that produces voice and has a microcomputer, the microcomputer repeatedly adjusts the levels of the audio control signal output from the audio control circuit and the drive voltage output from power control circuit step by step without actuation of a thermal protector circuit incorporated in the control IC according to a flowchart, thereby reducing uncomfortableness a viewer feels during volume adjustment and avoiding unnecessary adjustment during change in an input mode, the flowchart including:
a first step of determining whether a temperature of the control IC has reached a set temperature or not and advancing to a second step when the temperature of the control IC has reached the set temperature and advancing to a second step, whereas repeating the determination when the temperature of the control IC has not reached the set temperature;
the second step of storing on an EEPROM an initial value of the audio control signal and an initial value of the drive voltage and advancing to a third step;
the third step of reducing the level of the audio control signal by a first step amount and reducing the drive voltage by a first voltage and advancing to a fourth step;
the fourth step of displaying audio adjustment start information on a display and advancing to a fifth step;
the fifth step of monitoring the temperature of the control IC for a predetermined time period thereby to determine whether the temperature of the control IC has reached the set temperature or not, advancing to a sixth step when the temperature of the control IC has reached the set temperature, whereas advancing to a tenth step when the temperature of the control IC has not reached the set temperature;
a sixth step of determining whether the input mode has been changed between an internal input and an external input or not and, advancing to a twelfth step when the input mode has been changed, whereas advancing to a seventh step when the input mode has not been changed;
a seventh step of reducing the level of the audio control signal by a second step amount and reducing the drive voltage by a second voltage and thereafter advancing to an eighth step;
the eighth step of monitoring the temperature of the control IC for a predetermined time period thereby to determine whether the temperature of the control IC has reached the set temperature or not, advancing to the seventh step when the temperature of the control IC has reached the set temperature, whereas advancing to a ninth step when the temperature of the control IC has not reached the set temperature;
the ninth step of returning the level of the audio control signal by the second step amount and simultaneously returning the level of the drive voltage by a second voltage and advancing to the fifth step;
the tenth step of returning the levels of the audio control signal and the drive voltage to the initial values stored on the EEPROM respectively and advancing to an eleventh step;
the eleventh step of displaying audio adjustment completion information on the display by the OSD circuit and advancing to the first step;
the twelfth step of returning the levels of the audio control signal and the drive voltage to the initial values stored on the EEPROM respectively and advancing to a thirteenth step; and
the thirteenth step of displaying audio adjustment interrupt information on the display by the OSD circuit and advancing to the first step.
